# EUROPEAN PATENT APPLICATION

(11) **EP 2 980 989 A1**
(43) Date of publication of application: **03.02.2016**
(21) Application number: 13880585.8
(22) Date of filing: 26.03.2013
(51) Int. Cl.: H03F 1/06, H03F 3/21

(54) **POWER AMPLIFYING DEVICE AND POWER AMPLIFYING METHOD**

(71) Applicant: NEC Corporation, Tokyo 108-8001 (JP)
(72) Inventor: KOMORI, Hiroshi, Tokyo 108-8001 (JP)
(74) Representative: Vossius & Partner Patentanwälte Rechtsanwälte mbB
(86) International application number: PCT/JP2013/058667
(87) International publication number: WO 2014/155501

(57) **Abstract**

In the present invention, a power amplifying device comprises the following: a generation means for generating a second envelop signal generated by carrying out first signal processing on a first envelope signal that corresponds to the envelope of an input signal, and a third envelope signal generated by carrying out second signal processing on the first envelope signal; a first power supply voltage generation means for generating a first power supply voltage that varies in accordance with the second envelope signal; a second power supply voltage generation means for generating a second power supply voltage that varies in accordance with the third envelope signal; a first amplification means for generating a first amplified signal by amplifying an input signal using the first power supply voltage; and a second amplifying means for generating a second amplified signal by amplifying the first amplified signal using the second power supply voltage. The first signal processing is carried out in accordance with the specifications of the first amplification means, and the second signal processing is carried out in accordance with the specifications of the second amplification means.

## Description

### [Technical Field]

The present invention relates to a power amplifying device and a power amplifying method and, for example, to a power amplifying device including an amplifier of an Envelope Tracking system and a power amplifying method.

### [Background Art]

From the viewpoint of low power consumption and low CO₂ (carbon dioxide) emission, the efficiency enhancement of a power amplifier is required. Therefore, as a method for realizing the efficiency enhancement of the power amplifier, an amplifier of an Envelope Tracking system has received much attention in recent years.

The Envelope Tracking system refers to a system in which a power supply voltage of an amplifier is changed to cause the amplifier to operate in a state of being substantially saturated in accordance with amplitude information (an envelope signal) of an input signal to be amplified. Hereinafter, an amplifier of the Envelope Tracking system is also referred to as an ETPA (Envelope Tracking Power Amplifier).

PTL 1 describes a power amplifying device using an ETPA as a final-stage power amplifier.

### [Citation List]

### [Patent Literature]

[PTL 1] International Publication No. 2008/146354

### [Summary of Invention]

### [Technical Problem]

As described in PTL 1, in a power amplifying device using an ETPA as a final-stage power amplifier, a power amplifier of a stage preceding the final stage (e.g., a power amplifier of a driver stage) carries out amplification for a level of a signal to be amplified, in order to provide the signal to be amplified (e.g., RF (Radio Frequency) signal) of a sufficient level to the final-stage ETPA.

In view of the efficiency enhancement for the entire power amplifying device, it is conceivable to also configure the power amplifier of the stage preceding the final stage using an ETPA. In this case, it is conceivable to use an envelope signal used to adjust a power supply voltage of the ETPA of the final stage in order to also adjust a power supply voltage of the ETPA of the stage preceding the final stage.

The ETPA of the final stage and the ETPA of the stage preceding the final stage are different in needed specifications. The ETPA of the final stage needs high efficiency/high output, and the ETPA of the stage preceding the final stage needs high linearity/high gain.

To cause the ETPA to operate with high efficiency/high output, it is conceivable to adjust a power supply voltage of the ETPA and cause the ETPA to operate in a saturated region. To cause the ETPA to operate with high linearity/high gain, it is conceivable to control the power supply voltage of the ETPA to be higher than during saturated operation and cause the ETPA to operate in an unsaturated region.

Therefore, when an envelope signal used to adjust the power supply voltage of the ETPA of the final stage is used to adjust the power supply voltage of the ETPA of the stage preceding the final stage, it is difficult to cause the ETPA of the stage preceding the final stage to operate in accordance with specifications needed for the ETPA. Therefore, a method for causing each ETPA to operate in accordance with specifications is desired.

An object of the present invention is to provide a power amplifying device and a power amplifying method, which are capable of solving the problems described above.

### [Solution to Problem]

A power amplifying device of the present invention includes: a generation means that generates, on the basis of a first envelope signal that corresponds to an envelope of an input signal, a second envelope signal generated by carrying out first signal processing on the first envelope signal and a third envelope signal generated by carrying out second signal processing on the first envelope signal;
a first power supply voltage generation means that generates a first power supply voltage that varies in accordance with the second envelope signal;
a second power supply voltage generation means that generates a second power supply voltage that varies in accordance with the third envelope signal;
a first amplification means that generates a first amplified signal by amplifying the input signal using the first power supply voltage; and
a second amplification means that generates a second amplified signal by amplifying the first amplified signal using the second power supply voltage, wherein
the first signal processing is signal processing in accordance with specifications of the first amplification means, and the second signal processing is signal processing in accordance with specifications of the second amplification means.

A power amplifying method of the present invention is a power amplifying method carried out by a power amplifying device, the method includes:
generating, on the basis of a first envelope signal that corresponds to an envelope of an input signal, a second envelope signal generated by carrying out first signal processing on the first envelope signal and a third envelope signal generated by carrying out second signal processing on the first envelope signal;
generating a first power supply voltage that varies in accordance with the second envelope signal;
generating a second power supply voltage that varies in accordance with the third envelope signal;
generating a first amplified signal by amplifying the input signal using the first power supply voltage by a first amplification means; and
generating a second amplified signal by amplifying the first amplified signal using the second power supply voltage by a second amplification means, wherein
the first signal processing is signal processing in accordance with specifications of the first amplification means, and the second signal processing is signal processing in accordance with specifications of the second amplification means.

### [Advantageous Effect of Invention]

The present invention makes it possible to cause each amplification means to efficiently operate.

### [Brief Description of Drawings]

[Fig. 1A] Fig. 1A is a diagram illustrating a power amplifying device 1 according to one exemplary embodiment of the present invention.
[Fig. 1B] Fig. 1B is a diagram illustrating one example of an envelope signal processing circuit 50.
[Fig. 2] Fig. 2 is a chart illustrating examples of an envelope signal S40 for a driver stage and an envelope signal S50 for a final stage.
[Fig. 3] Fig. 3 is a diagram illustrating a power amplifying device including the envelope signal processing circuit 50, a modulation power supply 60, an ETPA 70, a modulation power supply 100, and an ETPA 110.
[Fig. 4] Fig. 4 is a diagram illustrating a power amplifying device in which an output signal of a pre-distortion compensation unit 20 is input to an envelope detection unit 40.
[Fig. 5] Fig. 5 is a diagram illustrating a power amplifying device in which a part of an RF signal S20 is input to the envelope detection unit 40.
[Fig. 6] Fig. 6 is a diagram illustrating a power amplifying device of a first modified example.
[Fig. 7A] Fig. 7A is a diagram illustrating a power amplifying device of a second modified example.
[Fig. 7B] Fig. 7B is a diagram illustrating one example of an envelope signal processing circuit 50A.

### [Description of Embodiments]

Hereinafter, one exemplary embodiment of the present invention will be described with reference to the drawings.

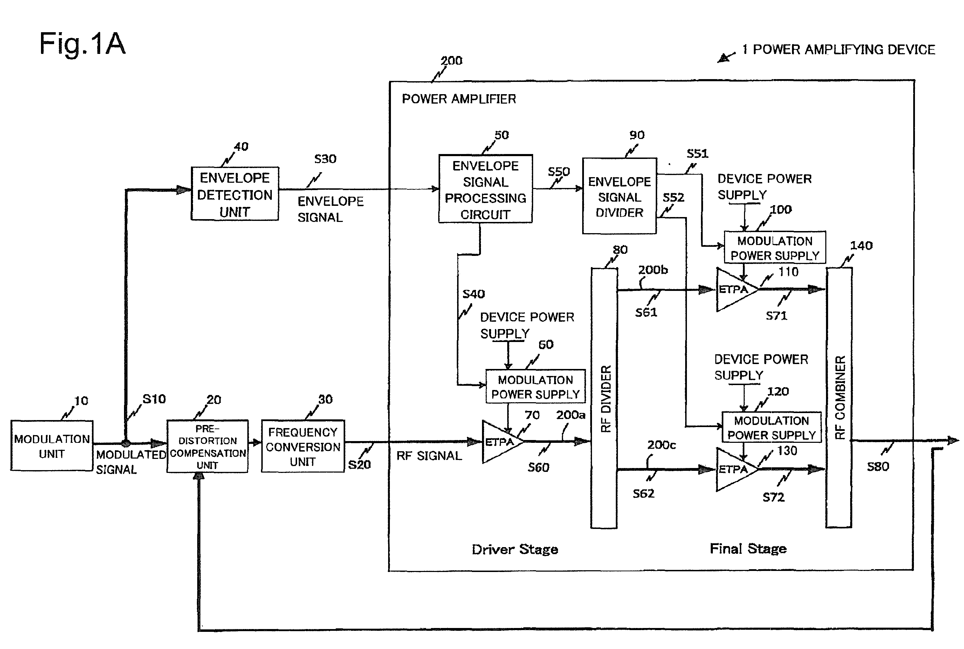

Fig. 1A is a diagram illustrating a power amplifying device 1 according to one exemplary embodiment of the present invention.

In Fig. 1A, the power amplifying device 1 includes a modulation unit 10, a pre-distortion compensation unit 20, a frequency conversion unit 30, an envelope detection unit 40, and a power amplifier 200.

The power amplifier 200 includes an envelope signal processing circuit 50, a modulation power supply 60, an ETPA 70, an RF divider 80, an envelope signal divider 90, a modulation power supply 100, an ETPA 110, a modulation power supply 120, an ETPA 130, and an RF combiner 140.

The power amplifier 200 includes two ETPAs (ETPAs 110 and 130) at a Final Stage and one ETPA (an ETPA 70) at a Driver Stage.

The modulation unit 10 generates a modulated signal S10, for example, an OFDM (Orthogonal Frequency Division Multiplexing) signal.

The pre-distortion compensation unit 20 processes the modulated signal S10 so as to cancel a distortion generated in the power amplifier 200.

The frequency conversion unit 30 converts the modulated signal S10 into an RF signal S20. The frequency conversion unit 30 converts the modulated signal S10 into the RF signal S20 so that an envelope of the modulated signal S10 matches an envelope of the RF signal S20. The RF signal S20 is one example of the input signal.

The envelope detection unit 40 detects the envelope of the modulated signal S10 and outputs an envelope signal S30 in accordance with the envelope. The envelope signal S30 is one example of the first envelope signal. The envelope signal S30 represents, for example, the envelope of the modulated signal S10 and the envelope of the RF signal S20.

The envelope signal processing circuit 50 is one example of the generation means. The envelope signal processing circuit 50 generates an envelope signal S40 for the Driver Stage and an envelope signal S50 for the Final Stage on the basis of the envelope signal S30.

Hereinafter, the envelope signal S40 for the Driver Stage is also referred to simply as "the envelope signal S40", and the envelope signal S50 for the Final Stage is also referred to simply as "the envelope signal S50".

The envelope signal S40 is one example of the second envelope signal. The envelope signal S50 is one example of the third envelope signal.

In the present exemplary embodiment, the envelope signal processing circuit 50 generates the envelope signal S40 by carrying out first signal processing on the envelope signal S30, and generates the envelope signal S50 by carrying out second signal processing on the envelope signal S30.

The first signal processing is signal processing in accordance with specifications (high linearity/high gain) of the ETPA 70 of the Driver Stage and is different from the second signal processing.

The second signal processing is signal processing in accordance with specifications (high efficiency/high output) of the ETPAs 110 and 130 of the Final Stage.

The modulation power supply 60 is one example of the first power supply voltage generation means. The modulation power supply 60 generates a power supply voltage for the ETPA 70 that varies in accordance with the envelope signal S40. The power supply voltage for the ETPA 70 is one example of the first power supply voltage.

The ETPA 70 is one example of the first amplification means. The ETPA 70 amplifies the RF signal S20 using the power supply voltage for the ETPA 70 from the modulation power supply 60 and generates an RF signal S60 that is the RF signal S20 after the amplification. The RF signal S60 is one example of the first amplified signal.

When a field-effect transistor is used as the ETPA 70, the power supply voltage for the ETPA 70 is supplied as the drain voltage of the ETPA 70. When a bipolar transistor is used as the ETPA 70, the power supply voltage for the ETPA 70 is supplied as the collector voltage of the ETPA 70.

The RF divider 80 divides the RF signal S60 into an RF signal S61 and an RF signal S62. Each of the RF signal S61 and the RF signal S62 is also one example of the first amplified signal.

The envelope signal divider 90 divides the envelope signal S50 into an envelope signal S51 and an envelope signal S52.

The modulation power supply 100 is one example of the second power supply voltage generation means. The modulation power supply 100 generates a power supply voltage for the ETPA 110 that varies in accordance with the envelope signal S51. The power supply voltage for the ETPA 110 is one example of the second power supply voltage.

The ETPA 110 is one example of the second amplification means. The ETPA 110 amplifies the RF signal S61 using the power supply voltage for the ETPA 110 from the modulation power supply 100 and generates an RF signal S71 that is the RF signal S61 after the amplification. The RF signal S71 is one example of the second amplified signal.

The modulation power supply 120 is one example of the second power supply voltage generation means. The modulation power supply 120 generates a power supply voltage for the ETPA 130 that varies in accordance with the envelope signal S52. The power supply voltage for the ETPA 130 is one example of the second power supply voltage.

The ETPA 130 is one example of the second amplification means. The ETPA 130 amplifies the RF signal S62 using the power supply voltage for the ETPA 130 from the modulation power supply 120 and generates an RF signal S72 that is the RF signal S62 after the amplification. The RF signal S72 is one example of the second amplified signal.

When field-effect transistors are used as the ETPAs 110 and 130, the power supply voltage for the ETPA 110 is supplied as the drain voltage of the ETPA 110, and the power supply voltage for the ETPA 130 is supplied as the drain voltage of the ETPA 130. When bipolar transistors are used as the ETPAs 110 and 130, the power supply voltage for the ETPA 110 is supplied as the collector voltage of the ETPA 110 and the power supply voltage for the ETPA 130 is supplied as the collector voltage of the ETPA 130.

The RF combiner 140 combines the RF signals S71 and S72 output from the ETPAs 110 and 130, respectively, and generates an RF signal S80.

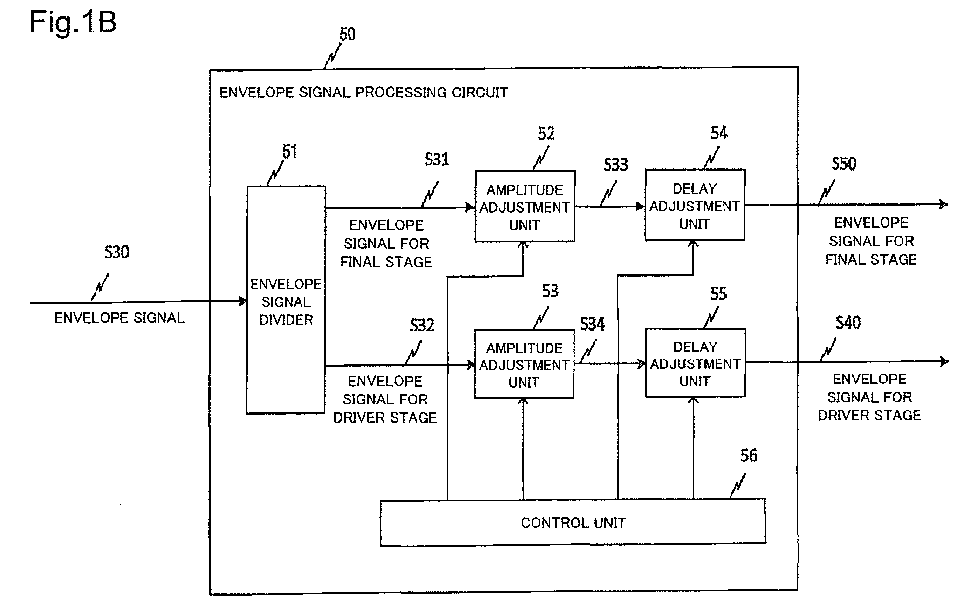

Fig. 1B is a diagram illustrating one example of the envelope signal processing circuit 50 illustrated in Fig. 1A.

In Fig. 1B, the envelope signal processing circuit 50 includes an envelope signal divider 51, amplitude adjustment units 52 and 53, delay adjustment units 54 and 55, and a control unit 56.

The envelope signal divider 51 divides the envelope signal S30 into an envelope signal S31 for the Final Stage and an envelope signal S32 for the Driver Stage.

The amplitude adjustment unit 52 adjusts an amplitude of the envelope signal S31 for the Final Stage so that the amplitude of the envelope signal S31 for the Final Stage is an amplitude suitable for the ETPAs 110 and 130. The amplitude adjustment unit 52 adjusts the amplitude of the envelope signal S31 for the Final Stage, for example, in accordance with specifications of the ETPAs 110 and 130.

In the present exemplary embodiment, the amplitude adjustment unit 52 receives first amplitude information set in accordance with the specifications of the ETPAs 110 and 130 from the control unit 56. The amplitude adjustment unit 52 adjusts the amplitude of the envelope signal S31 for the Final Stage on the basis of the first amplitude information from the control unit 56.

The amplitude adjustment unit 52 adjusts the amplitude of the envelope signal S31, for example, using an amplitude (a first amplitude) indicated by the first amplitude information. The amplitude indicated by the first amplitude information is, for example, an amplitude for causing the ETPAs 110 and 130 to operate in a saturated region.

The amplitude adjustment unit 53 adjusts an amplitude of the envelope signal S32 for the Driver Stage so that the amplitude of the envelope signal S32 for the Driver Stage is an amplitude suitable for the ETPA 70. The amplitude adjustment unit 53 adjusts the amplitude of the envelope signal S32 for the Driver Stage, for example, in accordance with specifications of the ETPA 70.

In the present exemplary embodiment, the amplitude adjustment unit 53 receives second amplitude information set in accordance with the specifications of the ETPA 70 from the control unit 56. The amplitude adjustment unit 53 adjusts the amplitude of the envelope signal S32 for the Driver Stage on the basis of the second amplitude information from the control unit 56.

The amplitude adjustment unit 53 adjusts the amplitude of the envelope signal S32, for example, using an amplitude (a second amplitude) indicated by the second amplitude information. The amplitude indicated by the second amplitude information is, for example, an amplitude for causing the ETPA 70 to operate in an unsaturated region.

The amplitude indicated by the first amplitude information (an amplitude for the Final Stage) is smaller than the amplitude indicated by the second amplitude information (an amplitude for the Driver Stage).

The delay adjustment unit 54 delays an envelope signal S33 for the Final Stage so that a phase of the power supply voltage for the ETPA 110 from the modulation power supply 100 matches a phase of the RF signal S61 and a phase of the power supply voltage for the ETPA 130 from the modulation power supply 120 matches a phase of the RF signal S62, and generates an envelope signal S50 for the Final Stage.

In the present exemplary embodiment, the delay adjustment unit 54 receives, from the control unit 56, first delay information indicating a delay amount of the envelope signal S33 for the Final Stage to match the phase of the power supply voltage for the ETPA 110 with the phase of the RF signal S61 and match the phase of the power supply voltage for the ETPA 130 with the phase of the RF signal S62. The delay adjustment unit 54 delays the envelope signal S33 for the Final Stage by the delay amount indicated by the first delay information and outputs the envelope signal S33 for the Final Stage after the delay as the envelope signal S50 for the Final Stage.

The delay adjustment unit 55 delays an envelope signal S34 for the Driver Stage so that a phase of the power supply voltage for the ETPA 70 from the modulation power supply 60 matches a phase of the RF signal S20 and generates an envelope signal S40 for the Driver Stage.

In the present exemplary embodiment, the delay adjustment unit 55 receives, from the control unit 56, second delay information indicating a delay amount of the envelope signal S34 for the Driver Stage to match the phase of the power supply voltage for the ETPA 70 with the phase of the RF signal S20. The delay adjustment unit 55 delays the envelope signal S34 for the Driver Stage by the delay amount indicated by the second delay information and outputs the envelope signal S34 for the Driver Stage after the delay as the envelope signal S40 for the Driver Stage.

Signal processing carried out in the amplitude adjustment unit 52 and signal processing carried out in the delay adjustment unit 54 are included in the second signal processing.

Signal processing carried out in the amplitude adjustment unit 53 and signal processing carried out in the delay adjustment unit 55 are included in the first signal processing.

For the control unit 56, the first amplitude information, the second amplitude information, the first delay information, and the second delay information are previously set. The control unit 56 provides the first amplitude information, the second amplitude information, the first delay information, and the second delay information to the amplitude adjustment unit 52, the amplitude adjustment unit 53, the delay adjustment unit 54, and the delay adjustment unit 55, respectively.

Next, operations will be described.

In the following description, an operation of the envelope signal processing circuit 50 that is the point of an operation of the power amplifying device 1 will be mainly described. Further, in the following description, it is assumed that the ETPAs 70, 110, and 130 have the same characteristics one another.

As described above, the ETPA (the ETPAs 110 and 130) of the Final Stage and the ETPA (the ETPA 70) of the Driver Stage are different in needed characteristics (specifications).

The ETPA of the Final Stage needs high efficiency/high output. Therefore, it is desirable that the ETPAs 110 and 130 of the Final Stage operate in a region where the RF signals S61 and S62 are saturated (a saturated region).

On the other hand, the ETPA of the Driver Stage needs high linearity/high gain. Therefore, it is desirable that the ETPA 70 of the Driver Stage operates in a region where the RF signal S20 is unsaturated (an unsaturated region).

Therefore, it is necessary to provide a high power supply voltage to the ETPA 70 of the Driver Stage so as to prevent the RF signal S20 from being saturated, compared with the ETPAs 110 and 130 of the Final Stage.

The power supply voltage supplied to the ETPA 70 of the Driver Stage increases with an increase in the amplitude of the envelope signal S40 from the envelope signal processing circuit 50.

The power supply voltages supplied to the ETPAs 110 and 130 of the Final Stage increase with an increase in the amplitude of the envelope signal S50 from the envelope signal processing circuit 50.

The envelope signal processing circuit 50 adjusts the amplitude of the envelope signal S40 and the amplitude of the envelope signal S50 so that the power supply voltage supplied to the ETPA 70 of the Driver Stage is higher than the power supply voltages supplied to the ETPAs 110 and 130 of the Final Stage.

For the control unit 56 in the envelope signal processing circuit 50, the user sets, for example, first amplitude information (e.g., a first amplitude) and a second amplitude information (e.g., a second amplitude) such that the power supply voltage supplied to the ETPA 70 of the Driver Stage is higher than the power supply voltages supplied to the ETPAs 110 and 130.

At that time, there are set the first amplitude information and the second amplitude information such that the ETPA 70 of the Driver Stage operates in an unsaturated region and the ETPAs 110 and 130 of the Final Stage operate in a saturated region.

The control unit 56 provides the first amplitude information to the amplitude adjustment unit 52 and the second amplitude information to the amplitude adjustment unit 53.

The amplitude adjustment unit 52 adjusts the amplitude of the envelope signal S31 for the Final Stage on the basis of the first amplitude information (the first amplitude) from the control unit 56. Further, the amplitude adjustment unit 53 adjusts the amplitude of the envelope signal S32 for the Driver Stage on the basis of the second amplitude information (the second amplitude) from the control unit 56.

In order for the ETPAs 110 and 130 to efficiently operate by the Envelope Tracking system, it is desirable that a phase of the RF signal S61 matches a phase of the power supply voltage from the modulation power supply 100, and a phase of the RF signal S62 matches a phase of the power supply voltage from the modulation power supply 120.

The phases of the power supply voltages from the modulation power supplies 100 and 120 depend on the phase of the envelope signal S50 from the envelope signal processing circuit 50.

The envelope signal processing circuit 50 adjusts a delay amount (a phase) of the envelope signal S50 so that the phases of the power supply voltages supplied to the ETPAs 110 and 130 match the phases of the RF signals S61 and S62, respectively.

For the control unit 56 in the envelope signal processing circuit 50, the user sets, for example, first delay information indicating a delay amount of the envelope signal S50 such that the phases of the power supply voltages supplied to the ETPAs 110 and 130 match the phases of the RF signals S61 and S62, respectively.

The control unit 56 provides the first delay information to the delay adjustment unit 54.

The delay adjustment unit 54 generates the envelope signal S50 by delaying the envelope signal S33 by the delay amount indicated by the first delay information from the control unit 56.

In order for the ETPA 70 to efficiently operate by the Envelope Tracking system, it is desirable that a phase of the RF signal S20 matches a phase of the power supply voltage from the modulation power supply 60.

The phase of the power supply voltage from the modulation power supply 60 depends on the phase of the envelope signal S40 from the envelope signal processing circuit 50.

The envelope signal processing circuit 50 adjusts a delay amount (a phase) of the envelope signal S40 so that the phase of the power supply voltage supplied to the ETPA 70 matches the phase of the RF signal S20.

For the control unit 56 in the envelope signal processing circuit 50, the user sets, for example, second delay information indicating a delay amount of the envelope signal S40 such that the phase of the power supply voltage supplied to the ETPA 70 matches the phase of the RF signal S20.

The control unit 56 provides the second delay information to the delay adjustment unit 55.

The delay adjustment unit 55 generates the envelope signal S40 by delaying the envelope signal S34 by the delay amount indicated by the second delay information from the control unit 56.

A difference between the delay amount indicated by the second delay information and the delay amount indicated by the first delay information is set as a value in accordance with a delay amount of an RF signal in a signal transmission unit that transmits an RF signal from the ETPA 70 to the ETPA 110 or a value in accordance with a delay amount of an RF signal in a signal transmission unit that transmits an RF signal from the ETPA 70 to the ETPA 130. The signal transmission unit includes a wiring 200a, the RF divider 80, and a wiring 200b, or the wiring 200a, the RF divider 80, and a wiring 200c.

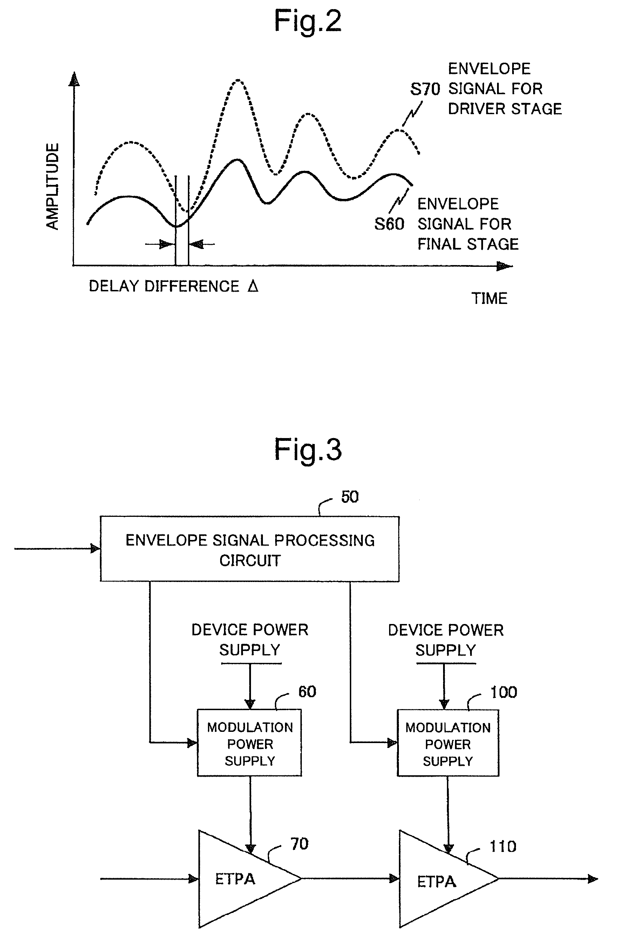

Fig. 2 is a chart illustrating examples of the envelope signal S40 for the Driver Stage and the envelope signal S50 for the Final Stage.

Next, advantageous effects of the present exemplary embodiment will be described.

According to the present exemplary embodiment, the envelope signal processing circuit 50 generates, on the basis of the envelope signal S30, the envelope signal S40 generated by carrying out the first signal processing in accordance with the specifications of the ETPA 70 on the envelope signal S30 and the envelope signal S50 generated by carrying out the second signal processing in accordance with the specifications of the ETPAs 110 and 130 on the envelope signal S30.

The modulation power supply 60 generates a power supply voltage for the ETPA 70 that varies in accordance with the envelope signal S40. The modulation power supply 100 generates a power supply voltage for the ETPA 110 that varies in accordance with the envelope signal S51 divided from the envelope signal S50. The modulation power supply 120 generates a power supply voltage for the ETPA 130 that varies in accordance with the envelope signal S52 divided from the envelope signal S50.

The ETPA 70 amplifies the RF signal S20 using the power supply voltage for the ETPA 70 and generates the RF signal S60. The ETPA 110 amplifies the RF signal S61 divided from the RF signal S60 using the power supply voltage for the ETPA 110 and generates the RF signal S71. The ETPA 130 amplifies the RF signal S62 divided from the RF signal S60 using the power supply voltage for the ETPA 130 and generates the RF signal S72.

Therefore, an envelope signal that corresponds to the ETPA can be generated for each of the ETPAs. This makes it possible for each ETPA to efficiently operate.

This advantageous effect is produced also by a power amplifying device including the envelope signal processing circuit 50, the modulation power supply 60, the ETPA 70, the modulation power supply 100, and the ETPA 110.

Fig. 3 is a diagram illustrating a power amplifying device including the envelope signal processing circuit 50, the modulation power supply 60, the ETPA 70, the modulation power supply 100, and the ETPA 110.

In the present exemplary embodiment, the first signal processing includes processing for generating the envelope signal S40 by adjusting an amplitude of the envelope signal S30 so that the ETPA 70 operates in an unsaturated region. This makes it possible for the ETPA 70 to operate the ETPA 70 in an unsaturated region and for the ETPA 70 to operate with high linearity/high gain. Further, a distortion of an RF signal generated in the power amplifying device 1 can be reduced.

In the present exemplary embodiment, the second signal processing includes processing for generating the envelope signal S50 by adjusting an amplitude of the envelope signal S30 so that the ETPAs 110 and 130 operate in a saturated region. This makes it possible for the ETPAs 110 and 130 to operate in a saturated region and for the ETPAs 110 and 130 to operate the with high efficiency/high output.

The first signal processing may include processing for generating the envelope signal S40 by adjusting the amplitude of the envelope signal S30 using a first amplitude, and the second signal processing may include processing for generating the envelope signal S50 by adjusting the amplitude of the envelope signal S30 using an amplitude smaller than the first amplitude. In this case, amplitude adjustments make it possible to generate the envelope signals S40 and S50.

In the present exemplary embodiment, the first signal processing includes processing for generating the envelope signal S40 by delaying the envelope signal S30 so that a phase of the power supply voltage for the ETPA 70 matches a phase of the RF signal S20. Therefore, the ETPA 70 can efficiently operate by the Envelope Tracking system.

In the present embodiment, the second signal processing includes processing for generating the envelope signal S50 by delaying the envelope signal S30 so that a phase of the power supply voltage for the ETPA 110 matches a phase of the RF signal S61 and a phase of the power supply voltage for the ETPA 130 matches a phase of the RF signal S62. This makes it possible for the ETPAs 110 and 130 to efficiently operate by the Envelope Tracking system.

A difference between a delay amount indicated by the second delay information and a delay amount indicated by the first delay information is set as a value in accordance with a delay amount of an RF signal in a signal transmission unit. Therefore, a difference between the envelope signal S40 and the envelope signal S50 in delay amount can be appropriately set.

In the present exemplary embodiment, the ETPA 70 and the ETPA 110 each as well as the ETPA 70 and the ETPA 130 each need not have the same characteristics.

In the present exemplary embodiment, a signal input to the envelope detection unit 40 may be an output signal of the pre-distortion compensation unit 20.

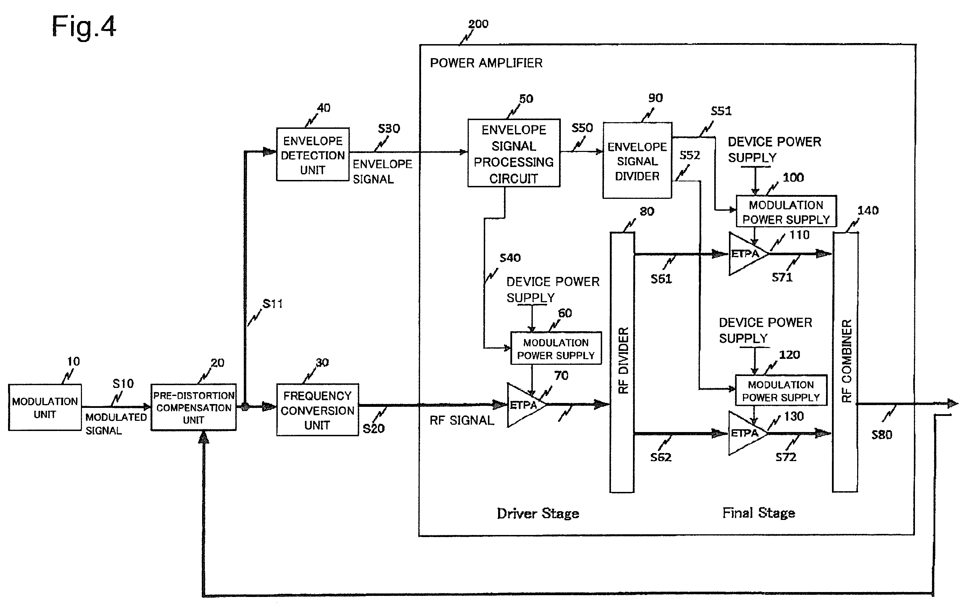

Fig. 4 is a diagram illustrating a power amplifying device in which an output signal S11 of the pre-distortion compensation unit 20 is input to the envelope detection unit 40. In Fig. 4, the same reference signs are assigned to the same components as in the one illustrated in Fig. 1A.

The signal input to the envelope detection unit 40 may be a part of the RF signal S20.

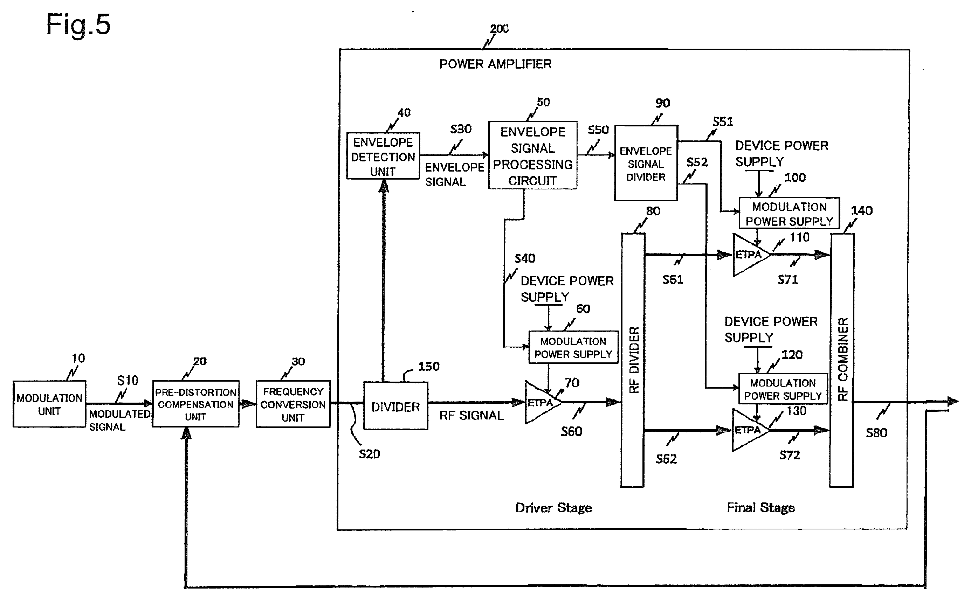

Fig. 5 is a diagram illustrating a power amplifying device in which a part of the RF signal S20 is input to the envelope detection unit 40. In Fig. 5, the same reference signs are assigned to the same components as in the one illustrated in Fig. 1A. The power simplifying device illustrated in Fig. 5 includes a divider 150 that divides the RF signal S20 for the envelope detection unit 40 and the ETPA 70.

The present exemplary embodiment may be modified as described below.

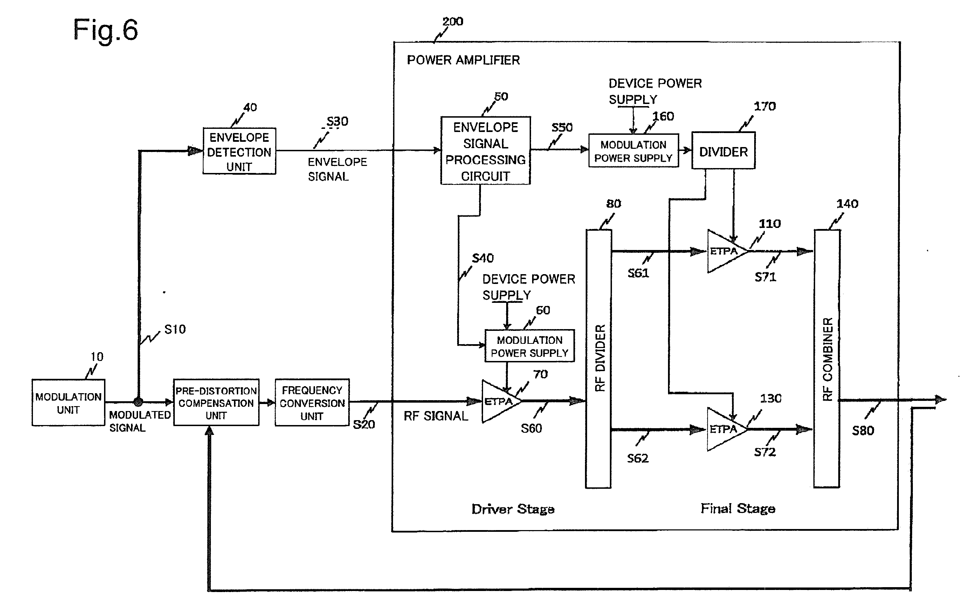

Fig. 6 is a diagram illustrating a power amplifying device of a first modified example of the present exemplary embodiment. In Fig. 6, the same reference signs are assigned to the same components as in the one illustrated in Fig. 1A.

In the modified example illustrated in Fig. 6, a modulation power supply 160 and a divider 170 are provided, and the envelope signal divider 90 and the modulation power supplies 100 and 120, which are illustrated in Fig. 1A, are omitted.

The modulation power supply 160 is one example of the second power supply voltage generation means. The modulation power supply 160 generates a power supply voltage for the ETPA of the Final Stage that varies in accordance with the envelope signal S50.

The divider 170 divides the power supply voltage for the ETPA of the Final Stage from the modulation power supply 160 for the ETPAs 110 and 130.

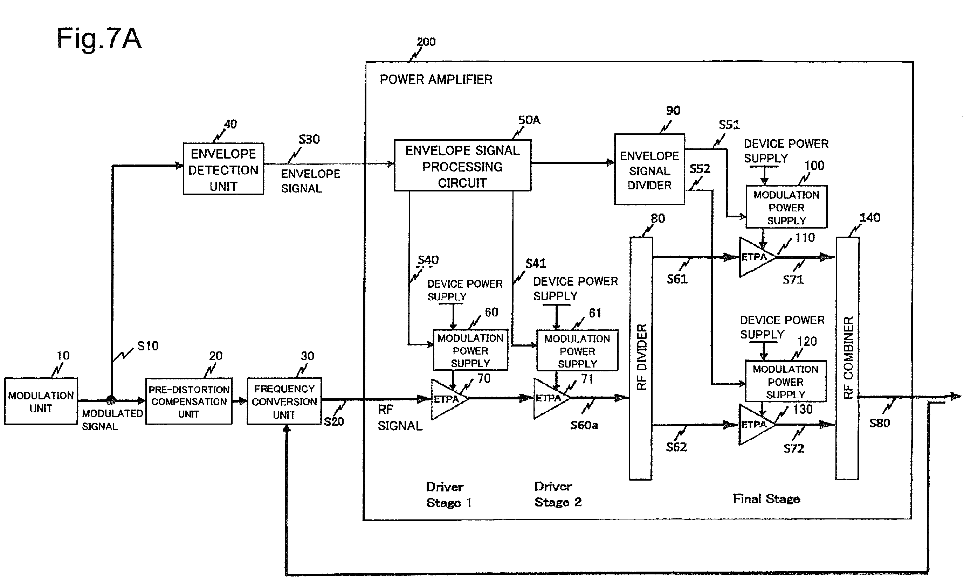

Fig. 7A is a diagram illustrating a power amplifying device of a second modified example of the present exemplary embodiment. In Fig. 7A, the same reference signs are assigned to the same components as in the one illustrated in Fig. 1A.

In the modified example illustrated in Fig. 7A, ETPAs 70 and 71 are cascade-connected at the Driver Stage. An envelope processing circuit 50A generates an envelope signal S41 in addition to the envelope signals S40 and S50 and outputs the envelope signal S41 to a modulation power supply 61.

The modulation power supply 61 generates a power supply voltage for the ETPA 71 that varies in accordance with the envelope signal S41.

The ETPA 71 amplifies an output signal of the ETPA 70 using the power supply voltage for the ETPA 71 from the modulation power supply 61.

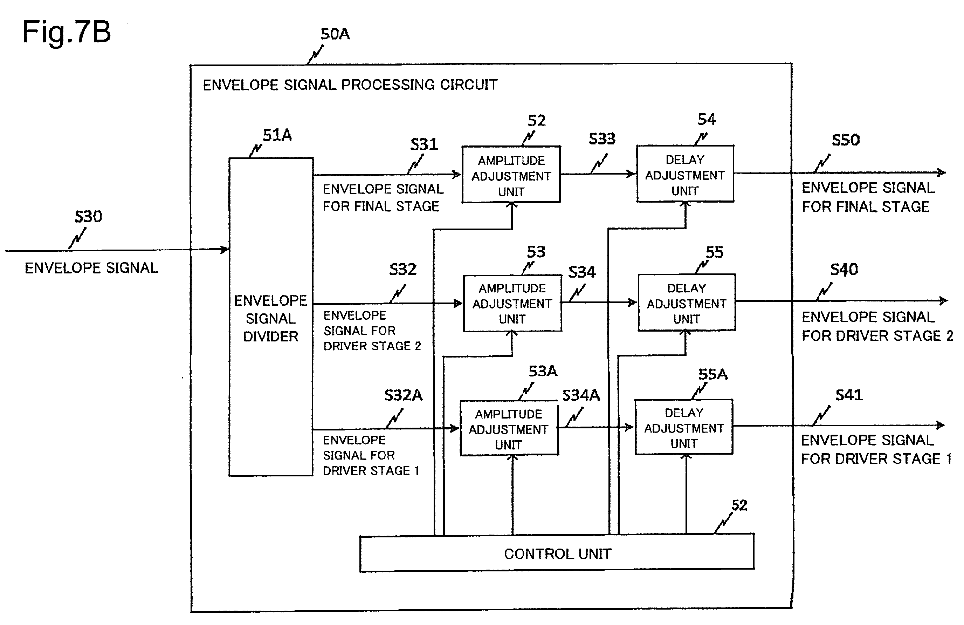

Fig. 7B is a diagram illustrating one example of the envelope signal processing circuit 50A illustrated in Fig. 7A. In Fig. 7B, the same reference signs are assigned to the same components as in the one illustrated in Fig. 1B. The envelope signal processing circuit 50A is described below by focusing on the difference from the envelope signal processing circuit 50 illustrated in Fig. 1B.

In Fig. 7B, an envelope signal divider 51 A divides an envelope signal S30 into an envelope signal S31 for the Final Stage, an envelope signal S32 for the Driver Stage, and an envelope signal S32A for the Driver Stage.

An amplitude adjustment unit 53A adjusts an amplitude of the envelope signal S32A for the Driver Stage so that the amplitude of the envelope signal S32A for the Driver Stage is an amplitude suitable for the ETPA 71. The amplitude adjustment unit 53A adjusts the amplitude of the envelope signal S32A for the Driver Stage, for example, in accordance with specifications of the ETPA 71.

In the present exemplary embodiment, the amplitude adjustment unit 53A receives third amplitude information set in accordance with the specifications of the ETPA71 from the control unit 56. The amplitude adjustment unit 53A adjusts the amplitude of the envelope signal S32A for the Driver Stage on the basis of the third amplitude information from the control unit 56.

The amplitude adjustment unit 53A adjusts the amplitude of the envelope signal S32A, for example, using an amplitude indicated by the third amplitude information. The amplitude indicated by the third amplitude information is, for example, an amplitude for causing the ETPA 71 to operate in an unsaturated region.

The amplitude indicated by the first amplitude information (an amplitude for the Final Stage) is smaller than the amplitude indicated by the third amplitude information (an amplitude for the Driver Stage).

A delay adjustment unit 55A delays an envelope signal S34A for the Driver Stage so that a phase of the power supply voltage for the ETPA 71 from the modulation power supply 61 matches a phase of an RF signal from the ETPA 70 and generates an envelope signal S41 for the Driver Stage.

In the present modified example, the delay adjustment unit 55A receives, from the control unit 56, third delay information indicating a delay amount of the envelope signal S34A for the Driver Stage to match the phase of the power supply voltage for the ETPA 71 with the phase of the RF signal from the ETPA70. The delay adjustment unit 55A delays the envelope signal S34A for the Driver Stage by the delay amount indicated by the third delay information.

For the control unit 56, the third amplitude information and the third amplitude information are previously set.

In the exemplary embodiment and each modified example having been described above, the illustrated configuration is merely one example, and therefore the present invention is not limited to the configuration thereof.

### [Reference signs List]

- 1: power amplifying device
- 10: modulation unit
- 20: pre-distortion compensation unit
- 30: frequency conversion unit
- 40: envelope detection unit
- 50, 50A: envelope signal processing circuit
- 51: envelope signal divider
- 52, 53, 53A: amplitude adjustment unit
- 54, 55, 55A: delay adjustment unit
- 56: control unit
- 60, 61, 100, 120, 160: modulation power supply
- 70, 71, 110, 130: ETPA
- 80: RF divider
- 90: envelope signal divider
- 140: RF combiner
- 150, 170: divider
- 200: power amplifier

## Claims

1. A power amplifying device comprising:
a generation means for generating, on the basis of a first envelope signal that corresponds to an envelope of an input signal, a second envelope signal generated by carrying out first signal processing on the first envelope signal and a third envelope signal generated by carrying out second signal processing on the first envelope signal;
a first power supply voltage generation means for generating a first power supply voltage that varies in accordance with the second envelope signal;
a second power supply voltage generation means for generating a second power supply voltage that varies in accordance with the third envelope signal;
a first amplification means for generating a first amplified signal by amplifying the input signal using the first power supply voltage; and
a second amplification means for generating a second amplified signal by amplifying the first amplified signal using the second power supply voltage, wherein
the first signal processing is signal processing in accordance with specifications of the first amplification means, and
the second signal processing is signal processing in accordance with specifications of the second amplification means.

2. The power amplifying device according to Claim 1,
wherein the first signal processing comprises processing for adjusting an amplitude of the first envelope signal so that the first amplification means operates in an unsaturated region.

3. The power amplifying device according to Claim 1 or Claim 2, wherein the second signal processing comprises processing for adjusting an amplitude of the first envelope signal so that the second amplification means operates in a saturated region.

4. The power amplifying device according to any one of Claim 1 to Claim 3, wherein
the first signal processing comprises processing for adjusting the amplitude of the first envelope signal using a first amplitude, and
the second signal processing comprises processing for adjusting the amplitude of the first envelope signal using an amplitude smaller than the first amplitude.

5. The power amplifying device according to any one of Claim 1 to Claim 4, wherein the first signal processing comprises processing for delaying the first envelope signal so that a phase of the first power supply voltage matches a phase of the input signal.

6. The power amplifying device according to any one of Claim 1 to Claim 5, wherein the second signal processing comprises processing for delaying the first envelope signal so that a phase of the second power supply voltage matches a phase of the first amplified signal.

7. The power amplifying device according to any one of Claim 1 to Claim 6, further comprising a signal transmission means for transmitting the first amplified signal to the second amplification means, wherein
the generation means adjusts a difference in delay amount between the second envelope signal and the third envelope signal in accordance with a delay amount of the first amplified signal in the signal transmission means.

8. A power amplifying method carried out by a power amplifying device, the method comprising:
generating, on the basis of a first envelope signal that corresponds to an envelope of an input signal, a second envelope signal generated by carrying out first signal processing on the first envelope signal and a third envelope signal generated by carrying out second signal processing on the first envelope signal;
generating a first power supply voltage that varies in accordance with the second envelope signal;
generating a second power supply voltage that varies in accordance with the third envelope signal;
generating a first amplified signal by amplifying the input signal using the first power supply voltage by a first amplification means; and
generating a second amplified signal by amplifying the first amplified signal using the second power supply voltage by a second amplification means, wherein
the first signal processing is signal processing in accordance with specifications of the first amplification means, and
the second signal processing is signal processing in accordance with specifications of the second amplification means.
